# EUROPÄISCHE PATENTANMELDUNG

(11) **EP 1 612 869 A2**
(43) Veröffentlichungstag der Anmeldung: **04.01.2006**
(21) Anmeldenummer: 05008671.9
(22) Anmeldetag: 20.04.2005
(51) Int. Cl.: H01L 33/00

(54) **Strahlungsemittierender Halbleiterschip mit einem Strahlformungselement und Strahlformungselement**

(30) Priorität: 30.06.2004 DE 102004031732
(71) Anmelder: Osram Opto Semiconductors GmbH, 93049 Regensburg (DE)
(72) Erfinder: Streubel, Klaus, 93164 Laaber (DE)
(74) Vertreter: Epping - Hermann - Fischer

(57) **Zusammenfassung**

Bei einem strahlungsemittierenden Halbleiterchip (2) mit einem Strahlformungselement ist das Strahlformungselement ein Hohlkörper (1) mit einer Lichtaustrittsöffnung (7). Bei einer ersten Ausführungsform der Erfindung weist der Halbleiterchip (2) eine der Lichtaustrittsöffnung (7) gegenüberliegende Lichteintrittsöffnung (8) auf, an die der Halbleiterchip (2) angrenzt. Bei einer zweiten Ausführungsform ist der Halbeleiterchip (2) innerhalb des Hohlkörpers (1) angeordnet. Zumindest ein Teil der von dem Halbleiterchip (2) emittierten Strahlung (3) wird an einer Wand (6) des Hohlkörpers (1) zur Lichtaustrittsöffnung (7) hin reflektiert.

## Beschreibung

Die Erfindung betrifft einen strahlungsemittierenden Halbleiterchip nach dem Oberbegriff des Patentanspruches 1 und ein Strahlformungselement.

Diese Patentanmeldung beansprucht die Priorität der deutschen Patentanmeldung 102004031732.1, deren Offenbarungsgehalt hiermit durch Rückbezug aufgenommen wird.

Zur Verbesserung der Strahlqualität, insbesondere zur Verringerung der Strahldivergenz und/oder des Strahlquerschnitts, werden in optoelektronischen Bauelementen mit strahlungsemittierenden Halbleiterchips, zum Beispiel in Lumineszenzdioden, oftmals Strahlformungselemente, wie beispielsweise Linsen und Lichtleiter, verwendet, die dem Halbleiterchip in der Hauptstrahlungsrichtung nachgeordnet sind.

Ein Beispiel für ein derartiges Strahlformungselement ist ein Lichtleiter aus einem Kunststoff-Vollkörper, der eine Lichteintrittsseite und eine Lichtaustrittsseite aufweist. Solche Lichtleiter sind beispielsweise in Siemens Components 29 (1991) Heft 5, Seiten 193 bis 196 beschrieben. Bei den dort erläuterten Lichtleitern wird eine von einem LED-Bauelement emittierte Strahlung durch die Lichteintrittsseite in den Lichtleiter eingekoppelt, an den Grenzflächen des Lichtleiters zur umgebenden Atmosphäre reflektiert, und im weiteren Verlauf durch die Lichtaustrittsseite wieder aus dem Lichtleiter ausgekoppelt.

Die von dem Halbleiterchip emittierte Strahlung gelangt in der Regel durch einen Luftspalt vom Halbleiterchip zur Lichteintrittsöffnung des Konzentrators. Dies hat jedoch den Nachteil, dass ein Teil der von dem Halbleiterchip emittierten Strahlung an der Lichteintrittsfläche des Konzentrators zurückreflektiert wird und somit verloren geht.

Bei einem Lichtleiter aus einem Kunststoff besteht in Verbindung mit Halbleiterchips, die Strahlung oder zumindest Strahlungsanteile im ultravioletten Spektralbereich emittieren, das Problem, dass der Kunststoff durch die UV-Strahlung degradiert, wodurch insbesondere die Langzeitstabilität beeinträchtigt werden kann. Dieses Problem tritt insbesondere bei Halbleiterchips auf, die blaues oder weißes Licht emittieren, da deren Emissionsspektrum bis in den ultravioletten Bereich des Spektrums hineinreicht.

Der Erfindung liegt die Aufgabe zugrunde, einen strahlungsemittierenden Halbleiterchip mit einem verbesserten Strahlformungselement sowie ein solches Strahlformungselement anzugeben, das sich insbesondere durch verringerte Verluste bei der Strahlungseinkopplung und eine vergleichsweise hohe Beständigkeit gegen ultraviolette Strahlung auszeichnet.

Diese Aufgabe wird durch einen strahlungsemittierenden Halbleiterchip mit einem Strahlformungselement mit den Merkmalen des Patentanspruchs 1 bzw. durch ein Strahlformungselement mit den Merkmalen des Patentanspruches 15 gelöst. Vorteilhafte Ausgestaltungen und Weiterbildungen der Erfindung sind Gegenstand der abhängigen Ansprüche. Der Offenbarungsgehalt der Patentansprüche wird hiermit ausdrücklich in die Beschreibung der Erfindung aufgenommen.

Bei einem strahlungsemittierenden Halbleiterchip mit einem Strahlformungselement gemäß einer ersten Ausführungsform der Erfindung ist das Strahlformungselement ein Hohlkörper mit einer Lichtaustrittsöffnung und einer der Lichtaustrittsöffnung gegenüberliegenden Lichteintrittsöffnung, wobei der Halbleiterchip an die Lichteintrittsöffnung angrenzt und zumindest ein Teil der von dem Halbleiterchip emittierten Strahlung an einer Wandung des Hohlkörpers zur Lichtaustrittsöffnung hin reflektiert wird.

Bei einem strahlungsemittierenden Halbleiterchip mit einem Strahlformungselement gemäß einer zweiten Ausführungsform der Erfindung ist das Strahlformungselement ein Hohlkörper mit einer Lichtaustrittsöffnung und einer der Lichtaustrittsöffnung gegenüberliegenden Öffnung, wobei der Halbleiterchip innerhalb des Hohlkörpers angeordnet ist und zumindest ein Teil der von dem Halbleiterchip emittierten Strahlung an einer Wandung des Hohlkörpers zur Lichtaustrittsöffnung hin reflektiert wird.

Dadurch, dass der Halbleiterchip direkt an die Lichteintrittsöffnung des Hohlkörpers angrenzt oder innerhalb des Hohlkörpers angeordnet ist, sind Reflexionsverluste beim Eintritt der Strahlung in das Strahlformungselement vorteilhaft gering. Dies ist insbesondere vorteilhaft im Vergleich zu Strahlformungselementen, die durch einen Luftspalt von dem Halbleiterchip getrennt sind.

Ein weiterer Vorteil der Erfindung besteht darin, dass der Hohlkörper eine der Lichtaustrittsöffnung gegenüberliegende Öffnung aufweist, so dass der Hohlkörper entweder mit der Öffnung auf den Halbleiterchip aufgesetzt oder über den Halbleiterchip gestülpt werden kann. Im erstgenannten Fall erfüllt die Öffnung die Funktion einer Lichteintrittsöffnung. Die Montage und Justierung des Hohlkörpers kann dadurch vorteilhaft nach der Montage und der Kontaktierung des Halbleiterchips erfolgen. Dies ist beispielsweise bei einem vorgefertigten Chipgehäuse, in das ein Halbleiterchip nachträglich eingesetzt wird, nicht möglich.

Der Hohlkörper kann zum Beispiel mit einem Vergussmaterial gefüllt sein. Bei dem Vergussmaterial handelt es sich bevorzugt um ein UV-stabiles Material, wie beispielsweise Silikon.

Die Wandung des Hohlkörpers weist bevorzugt eine Krümmung auf, um eine gewünschte optische Funktionalität zu realisieren. Insbesondere kann die Wandung des Hohlkörpers asphärisch, beispielsweise parabolisch, elliptisch oder hyperbolisch, gekrümmt sein.

Vorteilhaft wird die Divergenz der von dem Halbleiterchip emittierten Strahlung durch das Strahlformungselement vermindert. Eine vorteilhafte Ausführung des Hohlkörpers besteht darin, dass sich der Querschnitt des Hohlkörpers von der Lichtaustrittsöffnung zu der gegenüberliegenden Öffnung hin verjüngt. Weiterhin kann der Hohlkörper eine Symmetrieachse aufweisen, die parallel zu einer Hauptstrahlrichtung des strahlungsemittierenden Halbchips ist.

Besonders vorteilhaft ist die Erfindung für strahlungsemittierende Halbleiterchips, die weißes Licht, blaues Licht oder ultraviolette Strahlung emittieren, da durch die Verwendung eines Hohlkörpers als Strahlformungselement das Problem der UV-Beständigkeit im Vergleich zu bekannten Strahlformungselementen, die einen Vollkörper aus Kunststoff enthalten, vermindert ist.

Das Material des Hohlkörpers ist bevorzugt ein Material, das für die von dem Halbleiterchip emittierte Strahlung eine hohe Reflexion aufweist. Besonders vorteilhaft ist die Wandung des Hohlkörpers mit einer reflexionserhöhenden Beschichtung versehen.

Der Hohlkörper ist beispielsweise aus einem Kunststoff gefertigt. Besonders vorteilhaft ist es, wenn der Hohlkörper aus einem derart deformierbaren Material besteht, dass die Krümmung der Wandung veränderbar ist oder erst nach der Montage erzeugt wird. Die gewünschte optische Funktion des Hohlkörpers kann auf diese Weise noch nach der Montage verändert oder korrigiert werden. Durch diese Möglichkeit zur nachträglichen Korrektur der optischen Eigenschaften ist für die Montage des Halbleiterchips und des Hohlkörpers eine hohe Justagetoleranz gegeben. Der Montage- und Justageaufwand ist besonderes gering, wenn der Hohlkörper ein einstückiger Hohlköper ist.

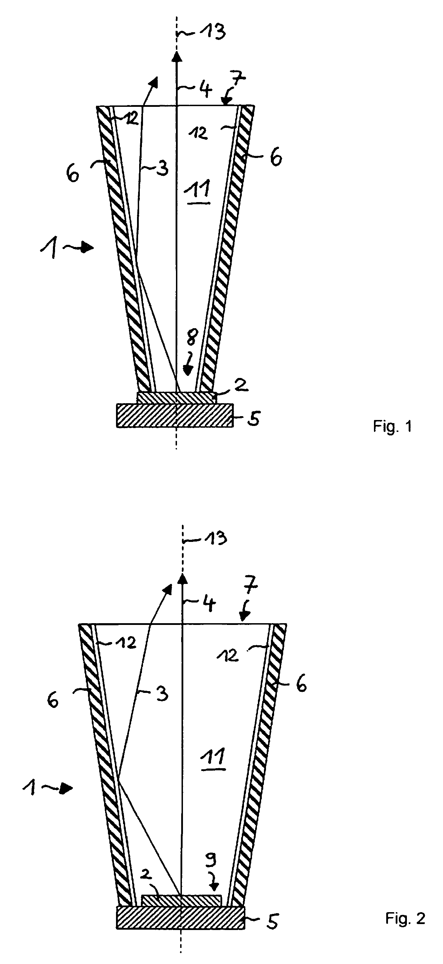

Die Erfindung wird im folgenden anhand von zwei Ausführungsbeispielen im Zusammenhang mit den Figuren 1 und 2 näher erläutert.

Es zeigen:
- Figur 1: eine schematische Darstellung eines Querschnitts durch ein Ausführungsbeispiel eines strahlungsemittierenden Halbleiterchips mit einem Strahlformungselement gemäß der ersten Ausführungsform der Erfindung und
- Figur 2: eine schematische Darstellung eines Querschnitts durch ein Ausführungsbeispiel eines strahlungsemittierenden Halbleiterchips mit einem Strahlformungselement gemäß der zweiten Ausführungsform der Erfindung.

Gleiche oder gleichwirkende Elemente sind in den Figuren mit den gleichen Bezugszeichen versehen.

Der in Figur 1 dargestellte strahlungsemittierende Halbleiterchip 2 ist mit einem Strahlformungselement versehen. Das Strahlformungselement ist ein Hohlkörper 1, der eine Lichtaustrittsöffnung 7 und eine Lichteintrittsöffnung 8 aufweist. Der Hohlkörper 1 ist derart auf den Halbleiterchip 2 aufgesetzt, dass die Lichteintrittsfläche 8 an den Halbleiterchip 2 angrenzt. Die von dem Halbleiterchip 2 emittierte Strahlung 3 wird an der Wandung 6 des Hohlkörpers 1 zur Lichtauskopplungsfläche 7 des Hohlkörpers hin reflektiert.

Der Hohlkörper 1 kann beispielsweise derart geformt sein, dass die Wandung 6 zwischen der Lichteintrittsfläche 8 und der Lichtaustrittsfläche 7, wie in der Figur 1 dargestellt, in der Richtung parallel zur Hauptstrahlrichtung 4 des Halbleiterchips 2 keine Krümmung aufweist.

Je nach gewünschter Funktion des Strahlformungselements kann die Wandung 6 aber auch in der Richtung parallel zur Hauptstrahlrichtung 4 des Halbleiterchips 2 eine Krümmung aufweisen, insbesondere eine asphärische Krümmung. Zum Beispiel kann eine parabolische, elliptische oder hyperbolische Krümmung vorgesehen sein, um beispielsweise die Strahldivergenz der von dem Halbleiterchip 2 emittierten Strahlung 3 zu verringern.

Der Hohlkörper 1 ist bevorzugt aus einem deformierbaren Material, beispielsweise einem Kunststoff, hergestellt. Die Krümmung der Wandung 6 kann in diesem Fall noch nach der Montage des Hohlkörpers auf den Halbleiterchip 2 erzeugt und/oder verändert werden.

Der Hohlkörper 1 ist rotationssymmetrisch um eine parallel zur Hauptstrahlrichtung 4 verlaufende Symmetrieachse 13. Da sich der Querschnitt des Hohlkörpers 1 in der gezeigten Ausführungsform von der Lichtaustrittsfläche 7 zur Lichteintrittsfläche 8 hin verjüngt, hat der Hohlkörper 1 die Form eines Kegelstumpfs.

Die Wandung 6 des Hohlkörpers 1 ist bevorzugt mit einer reflexionserhöhenden Beschichtung 12 versehen, die zum Beispiel ein Metall enthält. Diese Beschichtung 12 kann sowohl auf der Außenseite als auch auf der Innenseite der Wandung 6 aufgebracht sein. Eine reflexionserhöhende Beschichtung 12 ist insbesondere dann von Vorteil, wenn der Hohlkörper 1 aus einem Kunststoff besteht und der Halbleiterchip 2 Strahlung emittiert, deren Spektrum zumindest teilweise bis in den ultravioletten Spektralbereich hineinreicht, wie es beispielsweise bei Lumineszenzdioden der Fall ist, die blaues oder weißes Licht emittieren. In diesem Fall wird durch die reflexionserhöhende Beschichtung 12 nicht nur die Reflexion des Hohlkörpers 1 aus Kunststoff erhöht, sondern der Kunststoff auch vor der ultravioletten Strahlung geschützt, durch die der Kunststoff insbesondere nach längerer Betriebszeit geschädigt werden könnte.

Der Hohlkörper 1 ist vorzugsweise mit einer Vergussmasse 11 aufgefüllt, um zum Beispiel den Halbleiterchip 2 vor Umwelteinflüssen zu schützen. Weiterhin kann die Vergussmasse auch Lumineszenz-Konversionspartikel enthalten, um beispielsweise mit einem blaue oder ultraviolette Strahlung emittierenden Halbleiterchip 2 weißes Licht zu erzeugen. Für die zuvor genannten, zumindest teilweise im ultravioletten Spektralbereich emittierenden Halbleiterchips ist insbesondere Silikon als Vergussmaterial geeignet, da dieses sich durch eine hohe UV-Beständigkeit auszeichnet.

Der Halbleiterchip 2 ist beispielsweise auf einen Chipträger 5, insbesondere auf einen Leiterrahmen oder eine Leiterplatte montiert. Der Chipträger 5 kann Anschlussbereiche zur elektrischen Kontaktierung des Halbleiterchips 2 enthalten. Weiterhin kann der Chipträger 5 auch eine Wärmesenke umfassen.

Das in Figur 2 dargestellte Ausführungsbeispiel eines strahlungsemittierenden Halbleiterchips 2 mit einem Strahlformungselement gemäß der zweiten Ausführungsform der Erfindung unterscheidet sich von dem in Figur 1 dargestellten Ausführungsbeispiel im wesentlichen dadurch, dass der Hohlkörper 1 nicht auf den Halbleiterchip 2 aufgesetzt ist, sondern der Halbleiterchip 2 vollständig innerhalb des Hohlkörpers 1 angeordnet ist. Dies kann beispielsweise dadurch realisiert sein, dass der Hohlkörper 1 mit einer der Lichtaustrittsöffnung gegenüberliegenden Öffnung 9 derart auf den Chipträger 5 aufgesetzt ist, dass der auf den Chipträger 5 montierte Halbleiterchip 2 vollständig von dem Hohlkörper 1 umschlossen wird.

Alternativ kann der Halbleiterchip 2 auch in dem Hohlkörper 1 positioniert und mit der Vergussmasse 11 vergossen werden, so dass der Halbeleiterchip 2 nach dem Aushärten der Vergussmasse 11 auch ohne Chipträger in dem Hohlkörper 1 fixiert ist.

Auch die zweite Ausführungsform der Erfindung hat den Vorteil, dass die von dem Halbleiterchip 2 emittierte Strahlung 3 direkt in den als Strahlformungselement wirkenden Hohlkörper 1 eintritt, ohne zuvor einen Luftspalt zu passieren, wodurch Reflexionsverluste vermieden werden.

Die in den Figuren 1 und 2 dargestellten Ausführungsbeispiele eines Hohlkörpers 1 sind jeweils rotationssymmetrisch um eine parallel zur Hauptstrahlrichtung 4 der Halbleiterchips 2 verlaufende Symmetrieachse 13. Je nach gewünschter optischer Funktion des Strahlformungselements sind im Rahmen der Erfindung selbstverständlich auch andere Ausführungsformen des Hohlkörpers 1 denkbar.

Ferner können dem Hohlkörper 1 auch eines oder mehrere optische Elemente, beispielsweise eine Linse oder Linsenkombination, nachfolgen.

Die Hohlkörper 1 sind bei den Ausführungsbeispielen bevorzugt aus einem deformierbaren Material, beispielsweise einem Kunststoff, hergestellt. Die Krümmung der Wandung 6 kann in diesem Fall noch nach der Montage des Hohlkörpers 1 auf den Halbleiterchip 2 oder nach der Positionierung des Halbleiterchips 2 in dem Hohlkörper 1 erzeugt und/oder verändert werden. Insbesondere kann eine bereits vor der Montage vorhandene Krümmung der Wandung 6 nach der Montage korrigiert werden, um die gewünschten optischen Eigenschaften zu erzielen.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Strahlungsemittierender Halbleiterchip (2) mit einem Strahlformungselement,
**dadurch gekennzeichnet, dass**
das Strahlformungselement einen Hohlkörper (1) mit einer Lichtaustrittsöffnung (7) und einer der Lichtaustrittsöffnung (7) gegenüberliegenden Lichteintrittsöffnung (8) umfaßt,
der Halbleiterchip (2) an die Lichteintrittsöffnung (8) des Hohlkörpers (1) angrenzt oder durch die Lichteintrittsöffnung (8) des Hohlkörpers (1) in diesen hineinragt, derart, dass der Halbleiterchip (2) elektromagnetische Strahlung in den Hohlkörper (1) hinein emittiert und zumindest ein Teil dieser elektromagnetischen Strahlung (3) an einer Wandung (6) des Hohlkörpers (1) zur Lichtaustrittsöffnung (7) hin reflektiert wird.

2. Strahlungsemittierender Halbleiterchip (2) nach Anspruch 1,
**dadurch gekennzeichnet, dass**
zumindest ein Teil der elektromagnetischen Strahlung (3) an der Wandung (6) des Hohlkörpers (1) zur Lichtaustrittsöffnung (7) hin totalreflektiert wird.

3. Strahlungsemittierender Halbleiterchip (2) nach Anspruch 1 oder 2,
**dadurch gekennzeichnet, dass**
der Hohlkörper (1) mit einem strahlungsdurchlässigen Material (11) gefüllt ist.

4. Strahlungsemittierender Halbleiterchip (2) nach Anspruch 3,
**dadurch gekennzeichnet, dass**
das strahlungsdurchlässige Material (11) Silikon enthält, vorzugsweise ein Silikonharz ist.

5. Strahlungsemittierender Halbleiterchip (2) nach einem der vorhergehenden Ansprüche,
**dadurch gekennzeichnet, dass**
die Wandung (6) des Hohlkörpers (1) eine asphärische Krümmung aufweist.

6. Strahlungsemittierender Halbleiterchip (2) nach Anspruch 5,
**dadurch gekennzeichnet, dass**
die Wandung (6) des Hohlkörpers (1) parabolisch, elliptisch oder hyperbolisch gekrümmt ist.

7. Strahlungsemittierender Halbleiterchip (2) nach einem der vorhergehenden Ansprüche,
**dadurch gekennzeichnet, dass**
das Strahlformungselement die Divergenz der von dem Halbleiterchip (2) in den Hohlkörper (1) hinein emittierten Strahlung (3) vermindert.

8. Strahlungsemittierender Halbleiterchip (2) nach einem der vorhergehenden Ansprüche,
**dadurch gekennzeichnet, dass**
sich der Querschnitt des Hohlkörpers (1) von der Lichtaustrittsöffnung (7) zur Lichteintrittsöffnung (8, 9) hin verjüngt.

9. Strahlungsemittierender Halbleiterchip (2) nach einem der vorhergehenden Ansprüche,
**dadurch gekennzeichnet, dass**
der Hohlkörper (1) eine Symmetrieachse (13) aufweist, die parallel zu einer Hauptstrahlrichtung (4) des strahlungsemittierenden Halbleiterchips (2) ist.

10. Strahlungsemittierender Halbleiterchip (2) nach einem der vorhergehenden Ansprüche,
**dadurch gekennzeichnet, dass**
der Halbleiterchip (2) ultraviolette Strahlung emittiert.

11. Strahlungsemittierender Halbleiterchip (2) nach einem der vorhergehenden Ansprüche,
**dadurch gekennzeichnet, dass**
der Halbleiterchip (2) blaues oder weißes Licht emittiert.

12. Strahlungsemittierender Halbleiterchip (2) nach einem der vorhergehenden Ansprüche,
**dadurch gekennzeichnet, dass**
die Wandung (6) des Hohlkörpers (1) mit einer reflexionserhöhenden Beschichtung (12) versehen ist.

13. Strahlungsemittierender Halbleiterchip (2) nach einem der vorhergehenden Ansprüche,
**dadurch gekennzeichnet, dass**
der Hohlkörper (1) aus einem Kunststoffmaterial gefertigt ist.

14. Strahlungsemittierender Halbleiterchip (2) nach einem der vorhergehenden Ansprüche,
**dadurch gekennzeichnet, dass**
der Hohlkörper (1) aus einem derart deformierbaren Material besteht, dass die Krümmung der Wandung (6) veränderbar ist.

15. Strahlformungselement mit einem Hohlkörper (1), der eine Lichtaustrittsöffnung (7), eine der Lichtaustrittsöffnung (7) gegenüberliegende Lichteintrittsöffnung (8), durch die Licht eines strahlungsemittierenden Halbleiterchips (2) einkoppelbar ist, und eine die Lichtaustrittsöffnung (7) mit der Lichteintrittsöffnung (8) verbindende und den Hohlkörper (1) ausbildende Wandung (6) aufweist, wobei der Hohlkörper (1) mit einem strahlungsdurchlässigen Material (11) gefüllt ist.

16. Strahlformungselement nach Anspruch 15, bei dem das strahlungsdurchlässige Material (11) Silikon enthält, vorzugsweise ein Silikonharz ist.

17. Strahlformungselement nach Anspruch 15 oder 16, bei dem die Wandung (6) des Hohlkörpers (1) eine asphärische Krümmung aufweist.

18. Strahlformungselement nach Anspruch 17, bei dem die Wandung (6) des Hohlkörpers (1) parabolisch, elliptisch oder hyperbolisch gekrümmt ist.

19. Strahlformungselement nach einem der Ansprüche 15 bis 18, bei dem das Strahlformungselement die Divergenz einer von einem Halbleiterchip (2) in den Hohlkörper (1) hinein emittierten Strahlung (3) vermindert.

20. Strahlformungselement nach einem der Ansprüche 15 bis 19, bei dem sich der Querschnitt des Hohlkörpers (1) von der Lichtaustrittsöffnung (7) zur Lichteintrittsöffnung (8, 9) hin verjüngt.

21. Strahlformungselement nach einem der Ansprüche 15 bis 20, bei dem die Wandung (6) mit einer reflexionserhöhenden Beschichtung (12) versehen ist.

22. Strahlformungselement nach einem der Ansprüche 15 bis 21, bei dem
der Hohlkörper (1) aus einem Kunststoffmaterial gefertigt ist.

23. Strahlformungselement nach einem der Ansprüche 15 bis 22, bei dem
der Hohlkörper (1) aus einem derart deformierbaren Material besteht, dass die Krümmung der Wandung (6) veränderbar ist.
